# EUROPEAN PATENT SPECIFICATION

(11) **EP 3 614 369 B1**
(45) Date of publication and mention of the grant of the patent: **13.10.2021**
(21) Application number: 17906626.1
(22) Date of filing: 12.05.2017
(51) Int. Cl.: G09G 3/36, G02F 1/13, G11C 19/28, G09G 3/20

(54) **SCAN DRIVE CIRCUIT**
SCAN-TREIBERSCHALTUNG
CIRCUIT D'ATTAQUE DE BALAYAGE

(30) Priority: 21.04.2017 CN 201710265624
(43) Date of publication of application: 26.02.2020
(73) Proprietor: Shenzhen China Star Optoelectronics Semiconductor Display Technology Co., Ltd., Shenzhen, Guangdong 518132 (CN)
(72) Inventor: SHI, Longqiang, Shenzhen Guangdong 518132 (CN)
(74) Representative: Patentanwälte Olbricht Buchhold Keulertz
(86) International application number: PCT/CN2017/084119
(87) International publication number: WO 2018/192026

(56) References cited:
- CN-A- 101 765 876
- CN-A- 104 464 671
- CN-A- 106 057 161
- CN-A- 106 128 409
- CN-A- 106 531 109
- CN-U- 205 069 085
- US-A1- 2017 047 039

## Description

### Technical Field

The disclosure is related to the technical field of display technology, and more particular to a scanning driving circuit.

### Description of Related Art

GOA (Gate Driver on Array) technology is conducive to the display narrow frame design and cost reduction, has been widely used and researched. Indium gallium zinc oxide (IGZO) has high mobility and good device stability, can reduce the complexity of the scanning driving circuit. Due to the high mobility of IGZO, it makes the thin film transistor size of the scanning driving circuit be relatively small, is conducive to manufacture the narrow frame display; second, due to the device stability of IGZO, it can be used to reduce the power for stabilizing the thin film transistor performance and the number of the thin film transistors, so that the circuit is simple and low power consumption. However, due to the characteristic of IGZO material itself, the initial threshold voltage Vth is easy to be negative, and the influence of light will cause serious negative drift of the threshold voltage Vth, which may cause the scanning driving circuit malfunction. China publication number CN 106 128 409 A discloses a scan drive circuit that a control end of the 15th switch transistor T15 is connected to the second reference point K (n), an input of the 15th switch transistor T15 is connected to a constant low level source VSS, and an output of the 15th switch transistor T15 is connected with the driving module 12. China publication number CN 106 531 109 A discloses a GOA circuit and a liquid crystal display that an eighth transistor T8 is connected between a fifth transistor T5, a node P(N), and a low level Vss1.

### SUMMARY

The technical problem to be solved by the present invention is to provide a scanning driving circuit to prevent the circuit scanning driving circuit from malfunction caused by the threshold voltage being slightly negative.

To solve the above technical problem, the technical solution adopted by the present invention is to provide a scanning driving circuit according to claim 1.

Distinguishing from the current technology, the beneficial effects of this disclosure is that the scanning driving circuit of this disclosure may prevent electrical leakage by the pull-up circuit, the transfer circuit, the pull-up control circuit, the pull-down holding circuit, and the bootstrap circuit, thereby preventing the scanning driving circuit from malfunction caused by the threshold voltage being slightly negative.

### BRIEF DESCRIPTION OF THE DRAWINGS

Figure 1 is a circuit diagram of a first embodiment of the scanning driving circuit of the present invention.
Figure 2 is a relation diagram of signal waveform and electrical potential of Figure 1.
Figure 3 is a schematic diagram of a simulation signal waveform of Figure 1.
Figure 4 is a schematic diagram of a simulation signal waveform of the 32th-staged scanning driving unit of the scanning driving circuit of the disclosure.
Figure 5 is a schematic diagram of a simulation signal waveform of endurance of Figure 1.
Figure 6 is a circuit diagram of a second embodiment of the scanning driving circuit of the disclosure, which does not form part of the presently claimed invention.
Figure 7 is a relation diagram of the signal waveform and electrical potential of Figure 6.
Figure 8 is a schematic diagram of simulation signal waveform of the simulation of Figure 6.
Figure 9 is a schematic diagram of a simulation signal waveform of the 32th-staged scanning driving unit of the scanning driving circuit of the disclosure.
Figure 10 is a schematic diagram of a simulation signal waveform of endurance of Figure 6.

### DETAILED DESCRIPTION OF EMBODIMENTS

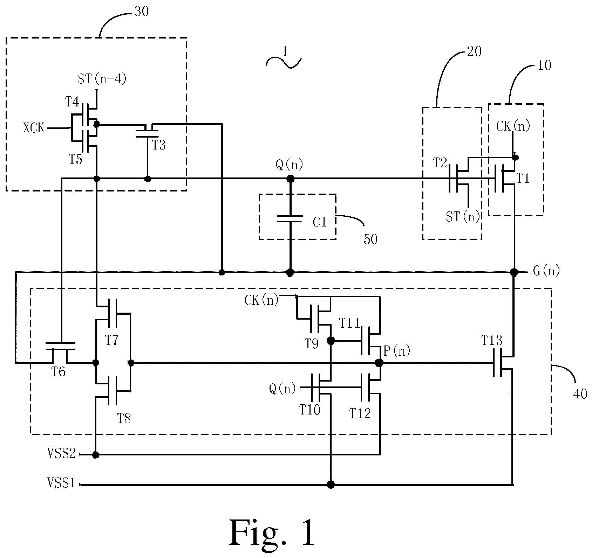

Referring to Figure 1, there is shown a circuit diagram of a first embodiment of the scanning driving circuit of this invention. The scanning driving circuit includes a plurality of scanning driving units 1, each of which includes a scanning signal output terminal G(n), for outputting a high voltage level scanning signal or a low voltage level scanning signal;
a pull-up circuit 10, for receiving the staged clock signal CK(n) and controlling the scanning signal output terminal G(n) to output a high voltage level scanning signal in accordance with the staged clock signal CK(n);
a transfer circuit 20, for connecting the pull-up circuit 10, for outputting a high voltage staged transmission signal ST(n);
a pull-up control circuit 30, for connecting the transfer circuit 20, for charging the pull-up control signal point Q(n) to pull the potential of the pull-up control signal point Q(n) to a high voltage level;
a pull-down holding circuit 40, connected to the pull-up control circuit 30 for maintaining the pull-up control signal point Q(n) and the scanning signal outputted from the scanning signal output terminal G(n) at a low voltage level;
a bootstrap circuit 50, for raising the potential of the pull-up control signal point Q(n).

The scanning driving unit 1 further includes a pull-down circuit 60, which is connected to the transfer circuit 20 and the pull-down holding circuit 40, for receiving a latter staged transmission signal ST(n+4) and controlling the scanning signal output terminal G(n) to output a low voltage level scanning signal in accordance with the staged transmission signal ST(n+4).

The pull-up circuit 10 includes a first controllable switch T1, a first terminal of the first controllable switch T1 receives the staged clock signal CK(n) and is connected to the transfer circuit 20, a control terminal of the controllable switch T1 is connected to the transfer circuit 20, and a second terminal of the first controllable switch T1 is connected to the pull-down holding circuit 40 and the scanning signal output terminal G(n).

The transfer circuit 20 includes a second controllable switch T2, a control terminal of the second controllable switch T2 is connected to the control terminal of the first controllable switch T1, a first terminal of the second controllable switch T2 is connected to the first terminal of the first controllable switch T1, a second terminal of the second controllable switch T2 outputs a staged transmission signal ST(n).

The pull-up control circuit 30 includes third to fifth controllable switches T3-T5 , a control terminal of the third controllable switch T3 is connected to the control terminal of the second controllable switch T2 , a fifth controllable switch T5, and the pull-down holding circuit 40, a first terminal of the third controllable switch T3 is connected to a second terminal of the fourth controllable switch T4 and a first terminal of the fifth controllable switch T5, a second terminal of the third controllable switch T3 is connected to the pull-down holding circuit 40, and a first terminal of the fourth controllable switch T4 receives the former staged transmission signal ST(n-4), a control terminal of the controllable switch T4 is connected to a control terminal of the fifth controllable switch T5 and receives a first clock signal XCK.

The pull-down holding circuit 40 includes sixth to thirteenth controllable switches T6-T13, a control terminal of the sixth controllable switch T6 is connected to the second terminal of the fifth controllable switch T5, a first terminal of the controllable switch T6 is connected to the second terminal of the third controllable switch T3, a second terminal of the sixth controllable switch T6 is connected to a second terminal of the seventh controllable switch T7 and a first terminal of the eighth controllable switch T8, a first terminal of the seventh controllable switch T7 is connected to the second terminal of the fifth controllable switch T5, a control terminal of the seventh controllable switch T7 is connected to a control terminal of the eighth controllable switch T8, a second terminal of the eighth controllable switch T8 is connected to a second voltage terminal VSS2, a control terminal of the ninth controllable switch T9 is connected to a first terminal of the ninth controllable switch T9 and a first terminal of the eleventh controllable switch T11 and receives the staged clock signal CK(n), a second terminal of the ninth controllable switch T9 is connected to a first terminal of the tenth controllable switch T10 and the control terminal of the tenth controllable switch T11, a control terminal of the tenth controllable switch T10 is connected to a control terminal of the twelfth controllable switch T12 and the pull-up control signal point Q(n), a second terminal of the tenth controllable switch T10 is connected to a first voltage terminal VSS1, a second terminal of the eleventh controllable switch T11 is connected to a first terminal of the twelfth controllable switch T12, a control terminal of the thirteenth controllable switch T13, and the control terminal of the eighth controllable switch T8, a second terminal of the twelfth controllable switch T12 is connected to the second voltage terminal VSS2, a first terminal of the thirteenth controllable switch T13 is connected to the second terminal of the first controllable switch T1, the scanning signal output terminal G(n), and the first terminal of the sixth controllable switch T6, a second terminal of the thirteenth controllable switch T13 is connected to the first voltage terminal VSS1.

The bootstrap circuit 50 includes a bootstrap capacitor C1, one terminal of which is connected to the control terminal of the third controllable switch T3, and the other terminal of the bootstrap capacitor C1 is connected to the second terminal of the third controllable switch T3.

In this embodiment, the first to thirteenth controllable switches T1-T13 are N-type thin film transistors, the control terminals, the first terminals, and the second terminals of the first to thirteenth controllable switches T1-T13 respectively correspond to the gates, the drains, and the sources of the N-type thin film transistors. In other embodiments, the first to thirteenth controllable switches may also be other types of switches as long as the objective of the disclosure can be achieved.

In this embodiment, a phase of the staged clock signal CK(n) is opposite to a phase of the first clock signal XCK, which are a group of high frequency AC power supplies. The first voltage terminal VSS1 and the second voltage terminal VSS2 are DC power supplies. This disclosure is illustrated by an example of 8K4K display in which eight clock signals are used, an overlap time between each of the two clock signals is 3.75 microseconds, a trigger signal STV has a pulse for each frame, and a pulse width is 30 microseconds, an overlap time between the trigger signal STV and the clock signal CK is 3.75 microseconds.

In this embodiment, a high potential of the clock signal CK is 28V and a low potential of which is -10V. Due to the fact that this embodiment adopts 8 clock signals CK, a clock signal CK1 is opposite to CK5, a clock signal CK2 is opposite to CK6, a clock signal CK3 is opposite to CK7, and a clock signal CK4 is opposite to CK8. The former staged transmission signals (N-4) is connected to a former fourth staged transmission signals, for example, when a current stage is tenth stage, thus ST(N)=ST(10), ST(N-4)=ST(6), that is, the first terminal of the fourth controllable switch T4 and a 6th-staged transmission signal are connected. Wherein, the first terminals of each fourth controllable switch T4 of the first four stages are connected to the trigger signal STV. A voltage of the first voltage terminal VSS1 is -5V, and a voltage of the second voltage terminal VSS2 is -10V.

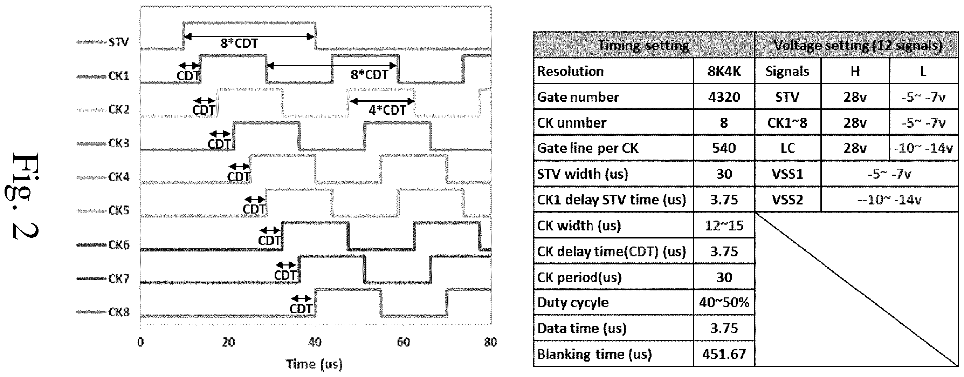

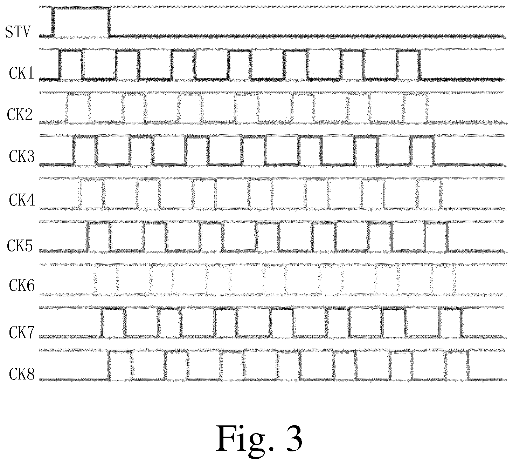

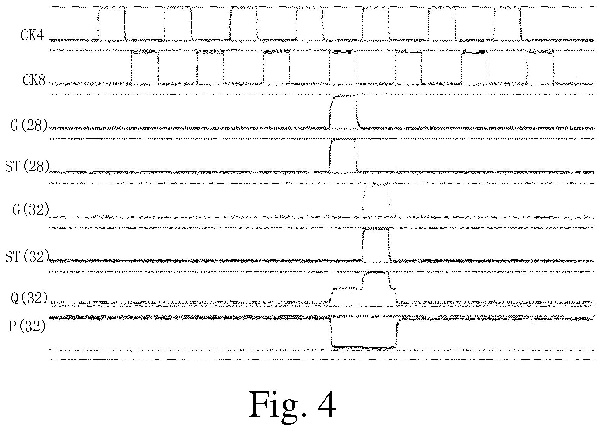

Referring to Figures 2 to 4, the scanning driving circuit of this embodiment will be described by taking the operation of the 32th-staged scanning driving unit as an example. That is, G(N)=G(32), ST(N-4)=ST(28), the scanning signal outputted from the scanning signal output terminal G(32) is controlled by a clock signal CK8, and a staged transmission signal ST (28)is controlled by a clock signal CK4, and the first clock signal XCK is the clock signal CK4.

When the staged transmission signal ST(28) is at a high potential, the clock signal CK4 is at a high potential, the fourth controllable switch T4 and the fifth controllable switch T5 are turned on; when a high potential of the staged transmission signal ST(28) is transmitted to a pull-up control signal point Q(32), the pull-up control signal point Q(32) is at a high potential, then first controllable switch T1 is turned on, at this time the clock signal CK8 is at a low potential, so the scanning signal outputted from the scanning signal output terminal G(32) is at a low potential, and at this time the ninth controllable switch T9 and the twelfth controllable switch T12 are turned on, and the second voltage terminal VSS2 pulls down the potential of the pull-down control signal point P(32), at this time the thirteenth controllable switch T13, the seventh controllable switch T7, and the eighth controllable switch T8 are turned off, so that the first voltage terminal VSS1 does not pull down the potential of the scanning signal outputted from the scanning signal output terminal G(32).

When the staged transmission signal ST(28)is at a low potential, the clock signal CK4 is at a low potential, and the fourth controllable switch T4 and the fifth controllable switch T5 are turned off. At this time, the clock signal CK8 is at a high potential, the scanning signal outputted from the scanning signal output terminal G(32) is at a high potential, and the pull-up control signal point Q(32) is pulled up to a higher potential by the coupling effect of the capacitance C1, a pull-down control signal point P(32) is remained at a low potential.

Here, it is necessary to explain how the scanning driving circuit of this disclosure prevents the circuit scanning driving circuit from malfunction caused by the threshold voltage being slightly negative.

In the present scanning driving circuit, when the threshold voltage of the pull-up control circuit 30 and the pull-down holding circuit 40 is too negative, the high potential of the pull-up control signal point Q(32) leaks to low potential from the pull-up control circuit 30 and the pull-down holding circuit 40,the high potential of the scanning signal outputted from the scanning signal output terminal G(32) also leaks to low potential, thus, it causes the circuit to fail to output a normal waveform, so that the circuit is malfunctioned.

The scanning driving circuit of this disclosure is effective for preventing leakage, when the threshold voltage Vth of the pull-up control circuit 30 is negative, the third controllable switch T3 is turned on, and a voltage of the first terminal of the fifth controllable switch T5 is 28V, the clock signal CK4 is at a low potential, so the voltage is -10V, then the voltage Vgs between gate and source of the fifth controllable switch T5 = -10V - 28V= -38V, as long as the threshold voltage Vth of the fifth controllable switch T5 is not less than -38V, thus the fifth controllable switch T5 is in the off state, so the high potential of the pull-up control signal point Q(32) will not leak from the pull-up control circuit 30, the principle for preventing the leakage of the pull-down holding circuit 40 is the same, so it will not be described here.

For the electrical leakage of the thirteenth controllable switch T13, if the potential of the first voltage terminal VSS1 is -5V,and the potential of the second voltage terminal VSS2 is -10V, and then the pull-down control signal point P (32) has a potential of - 10V,and the voltage Vgs between the gate and the source of the thirteenth controllable switch T13 is -10V - (-5V) = -5V, as long as the threshold voltage Vth of the thirteenth controllable switch T13 is not less than -5V, the fifth controllable switch T5 is in the off state, so that the high potential of the scanning signal outputted from the scanning signal output terminal G(32) does not leak from the thirteenth controllable switch T13.

When the clock signal CK8 is at a low potential, the scanning signal outputted from the scanning signal output terminal G (32) is pulled down to low potential, at the meantime, when the clock signal CK4 is at a high potential, the low potential of the staged transmission signal ST(28) is transmitted to the pull-up control signal point Q(32), the pull-up control signal point Q(32) is pulled to low potential. After the time, the clock signal CK8 is periodically at a high potential, and the pull-down control signal point P(32) is periodically at a high potential, the thirteenth controllable switch T13, the controllable switch T7, and the eighth controllable switch T8 are periodically turned on, then the pull-up control signal point Q(32) can well maintain the potential from the second voltage terminal VSS2, and the scanning signal outputted from the scanning signal output terminal G(32) can well maintain the potential from the first voltage terminal VSS1.

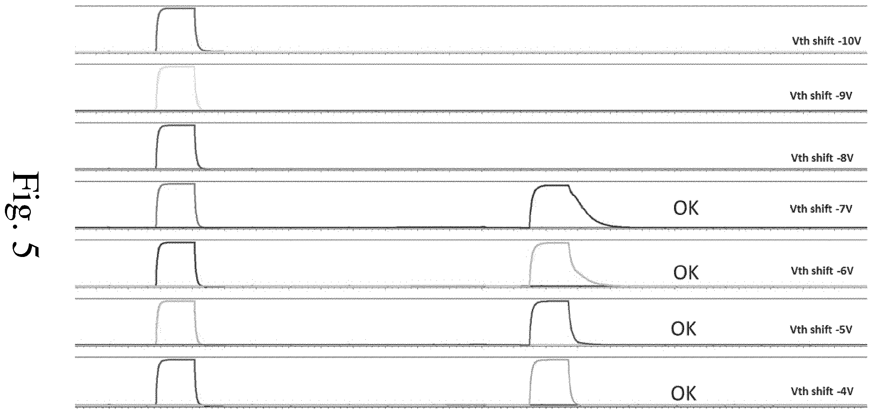

Referring to Figure 5, there is shown a schematic diagram of an endurance simulation signal waveform of a scanning driving circuit according to this disclosure. As shown in Figure 5, when the threshold voltage Vth is -7V, the scanning driving circuit can still work normally, indicating that the scanning driving circuit of this application is very good in endurance.

The scanning driving circuit prevents electrical leakage by the pull-up circuit, the transfer circuit, the pull-up control circuit, the pull-down holding circuit, the pull-down circuit, and the bootstrap circuit, thereby preventing the scanning driving circuit from malfunction caused by the threshold voltage being slightly negative.

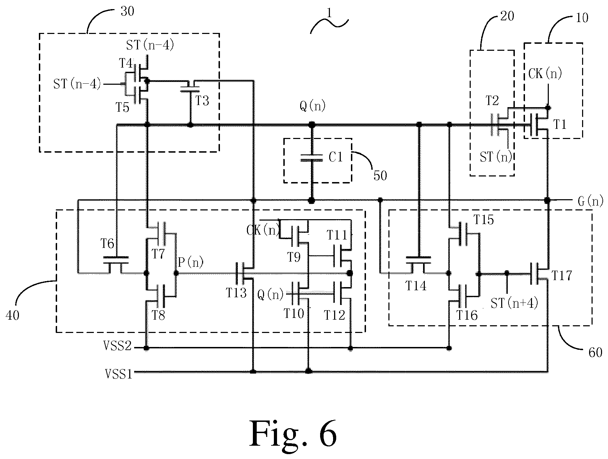

Referring to Figure 6, there is shown a circuit diagram of a second embodiment of the scanning driving circuit of this disclosure, which does not form part of the presently claimed invention. The second embodiment of the scanning driving circuit differs from the first embodiment in that the pull-up control circuit 30 includes third to fifth controllable switches T3-T5, the control terminal of the third controllable switch T3 is connected to the control terminal of the second controllable switch T2, the second terminal of the fifth controllable switch T5, and the pull-down holding circuit 40; the first terminal of the third controllable switch T3 is connected to the second terminal of the fourth controllable switch T4 and the first terminal of the fifth controllable switch T5, the second terminal of the third controllable switch T3 is connected to the pull-down holding circuit 40. The first terminal of the fourth controllable switch T4 receives the former staged transmission signal ST(n-4), the control terminal of the fourth controllable switch T4 is connected to the control terminal of the fifth controllable switch T5 and receives the former staged transmission signal ST (n-4).

The pull-down holding circuit 40 includes sixth to thirteenth controllable switches T6-T13, the control terminal of the sixth controllable switch T6 is connected to the second terminal of the fifth controllable switch T5, the first terminal of the sixth controllable switch T6 is connected to the second terminal of the third controllable switchT3, the second terminal of the sixth controllable switch T6 is connected to the second terminal of the seventh controllable switch T7 and the first terminal of the eighth controllable switch T8, the first terminal of the seventh controllable switch T7 is connected to the second terminal of the fifth controllable switch T5, the control terminal of the seventh controllable switchT7 is connected to the control terminal of the eighth controllable switch T8, the second terminal of the eighth controllable switch T8 is connected to the second voltage terminal VSS2. The control terminal of the ninth controllable switch T9 is connected to the first controllable switch T9 and the first terminal of the eleventh controllable switch T11 and receives the staged clock signal CK(n), the second terminal of the ninth controllable switch T9 is connected to the first terminal of the tenth controllable switch T10 and the control terminal of the eleventh controllable switch T11, the control terminal of the tenth controllable switch T10 is connected to the control terminal of the controllable switch T12 and the pull-up control signal point Q(n), the second terminal of controllable switch T10 is connected to the first voltage terminal VSSl,the second terminal of the eleventh controllable switch T11 is connected to the first terminal of the twelfth controllable switchT12, the control terminal of the thirteenth controllable switch T13, and the control terminal of the eighth controllable switch T8; the second terminal of the twelfth controllable switch T12 is connected to the second voltage terminal VSS2, the first terminal of the thirteenth controllable switchT13 is connected to the first terminal of the sixth controllable switch T6,the second terminal of the thirteenth controllable switch T13 is connected to the first voltage terminalVSS1.

The pull-down circuit 60 includes fourteenth to seventeenth controllable switches T14-T17, the control terminal of the fourteenth controllable switch T14 is connected to the first terminal of the fifteenth controllable switch T15 and the control terminal of the second controllable switch T2. The first terminal of the fourteenth controllable switch T14 is connected to the scanning signal output terminal G(n) and the first terminal of and the thirteenth controllable switch T13, the second terminal of the fourteenth controllable switch T14 is connected to the second terminal of the fifteenth controllable switch T15 and the first terminal of the sixteenth controllable switch T16, the control terminal of the fifteenth controllable switch T15 is connected to the control terminal of the sixteenth controllable switch T16 and the control terminal of the seventeenth controllable switch T17 and receives the latter staged transmission signal ST (n+4). The second terminal of the sixteenth controllable switch T16 is connected to the second voltage terminal VSS2, the first terminal of the seventeenth controllable switch T17 is connected to the scanning signal output terminal G(n), the second terminal of the seventeenth controllable switch T17 is connected to the first voltage terminal VSS1.

In this embodiment, the first to seventeenth controllable switches T1-T17 are all N-type thin film transistors, the control terminals, the first terminals, and the second terminals of the first to seventeenth controllable switches T1-T17respectively correspond to the gates, the drains, and the sources of the N-type thin film transistors. In other embodiments, the first to seventeenth controllable switches may also be other types of switches as long as the objective of this disclosure can be achieved.

In this embodiment, it is assumed that the high potential of the clock signal CK is 28V and the low potential is -10V. The scanning driving circuit adopts 8 clock signals CK, the staged transmission signal ST(N-4) is connected to the former fourth staged transmission signal, for example, when the current stage is the tenth stage, then ST(N) =ST(10), ST (N-4) = ST(6), ST (N + 4) = ST(10), that is, the first terminal of the fourth controllable switch T4 and the sixth staged transmission signal ST(6) are connected. The fourth controllable switch T4 of each scanning driving unit 1 of the first four stages is connected to the trigger signal STV, and the last fourth staged transmission signal ST(N+4) is replaced by the trigger signal STV. Here the voltage of the first voltage terminal VSS1 is - 5V, and the voltage of the second voltage terminal VSS2 is -10V.

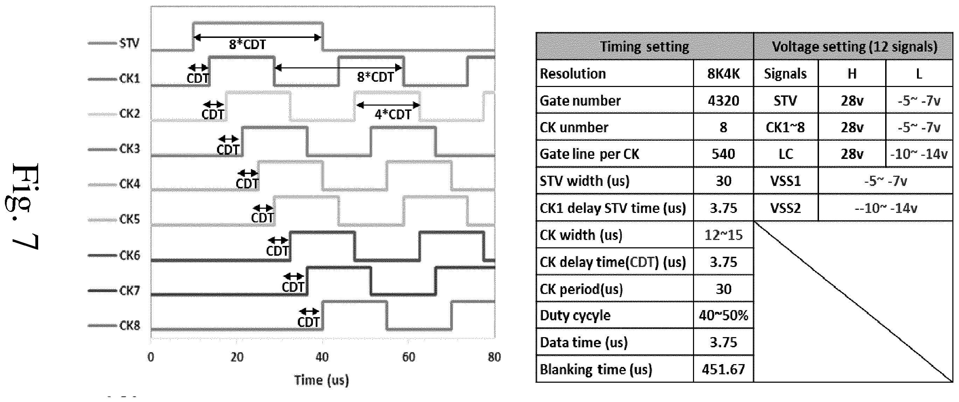

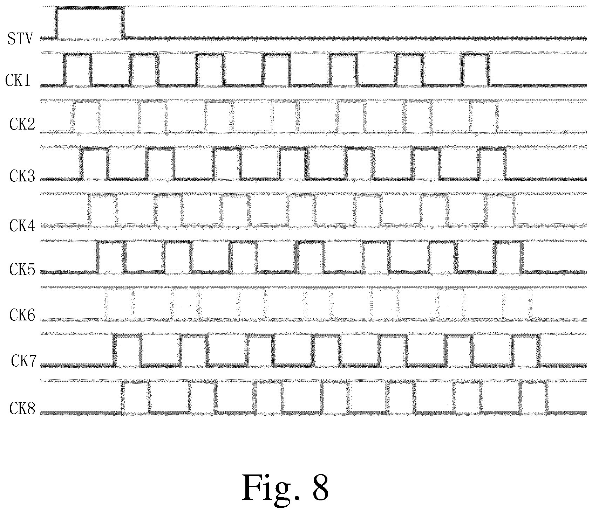

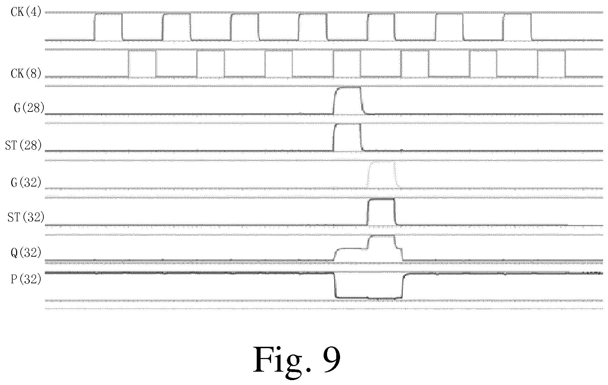

Referring to Figures 7 to 9, the scanning driving circuit of this embodiment will be described by taking the operation principle of the 32nd stage scanning driving unit as an example. That is, G(N)=G(32), ST(N - 4)=ST(28), ST(N+4)=ST(36). The scanning signal outputted from the scanning signal output terminal G(32) is controlled by the clock signal CK8, and the staged transmission signal ST(28) is controlled by the clock signal CK4.

When the staged transmission signal ST(28) is at a high potential, the clock signal CK4 is at a high potential, and the fourth controllable switch T4 and the fifth controllable switch T5 are turned on, a high potential of the staged transmission signal ST(28) is transmitted to a pull-up control signal point Q(32), the pull-up control signal point Q(32) is at a high potential, at this time then first controllable switch T1 is turned on, the clock signal CK8 is at a low potential, so the scanning signal outputted from the scanning signal output terminal G(32) is at a low potential, at the same time, the tenth controllable switch T10 and the twelfth controllable switch T12 are turned on, so that the second voltage terminal VSS2 pulls down the potential of the pull-down control signal point P(32), and then the thirteenth controllable switch T13, the seventh controllable switch T7, and the eighth controllable switch T8 are turned off. The low potential of the second voltage terminal VSS2 does not pull down the potential of the scanning signal outputted from the scanning signal output terminal G(32).

When the staged transmission signal ST(28) is at a low potential, the clock signal CK4 is at a low potential, and the fourth controllable switch T4 and the fifth controllable switch T5 are turned off, and at this time the clock signal CK8 is at a high potential, the scanning signal outputted from the scanning signal output terminal G(32) is at a high potential, and the pull-up control signal point Q(32) is pulled up to a higher potential by the coupling effect of the capacitance C1, a pull-down control signal point P(32) is remained at a low potential.

Here, it is necessary to explain how the scanning driving circuit of this disclosure prevents the circuit scanning driving circuit from malfunction caused by the threshold voltage being slightly negative.

When the threshold voltage Vth of the pull-up control circuit 30, the pull-down circuit 60, and the pull-down holding circuit 40 in the present scanning driving circuit is too negative, the high potential of the pull-up control signal point Q(32) leaks to low potential from the pull-up control circuit 30, the pull-down circuit 60, and the pull-down holding circuit 40, the high potential of the scanning signal outputted from the scanning signal output terminal G(32) also leaks to low potential by the pull-down circuit 60 and the pull-down holding circuit 40, thus it causes the circuit to fail to output a normal waveform, so that the circuit is malfunctioned.

The scanning driving circuit of this disclosure is effective for preventing leakage, when the threshold voltage Vth of the pull-up control circuit 30 is too negative, the third controllable switch T3 is turned on, and the voltage of the first terminal of the fifth controllable switch T5 is 28V, the clock signal CK4 is at a low potential, so the voltage is -10V, then the voltage Vgs between the gate and the source of the fifth controllable switch T5 =-10V-28V= -38V, as long as the threshold voltage Vth of the fifth controllable switch T5 is not less than -38V, thus the fifth controllable switch T5 is in the off state, so the high potential of the pull-up control signal point Q(32) will not leak from the pull-up control circuit 30, the principle for preventing the leakage of the pull-down holding circuit 40 is the same, so it will not be described here.

For the electrical leakage of the thirteenth controllable switch T13 and the seventeenth controllable switch T17, if the potential of the first voltage terminal VSS1 is -5V, and the potential of the second voltage terminal VSS2 is -10V, then the pull-down control signal point P (32) has a potential of -10V,and the voltage Vgs between the gate and the source of the thirteenth controllable switch T13 is -10V- (-5V) = -5V. As long as the threshold voltage Vth of the thirteenth controllable switch T13 is not less than -5V, the fifth controllable switch T5 is in the off state, so that the high potential of the scanning signal outputted from the scanning signal output terminal G(32) does not leak from the pull-down holding circuit 40. Similarly, if the staged transmission signal ST(36) is - 10V, and VSS1 is -5V, and the voltage Vgs between the gate and the source of the seventeenth controllable switch T17 is -5V, then the seventeenth controllable switch T17 is in a good off-state.

When the staged transmission signal ST (36) is at a high potential, the fourteenth to seventeenth controllable switches T14-T17 are turned on, the scanning signal outputted from the scanning signal output terminal G(32) and the pull-up control signal point Q(32) are pulled to a low potential; after that, the clock signal CK8 is periodically at a high potential, then the pull-down control signal point P(32) is periodically at a high potential, the sixth to eighth controllable switches T6-T8 and the thirteenth controllable switch T13 are periodically turned on, then the pull-up control signal point Q(32) can well maintain the potential from the second voltage terminal VSS2, and the scanning signal outputted from the scanning signal output terminal G(32) can well maintain at the potential from the first voltage terminal VSS1.

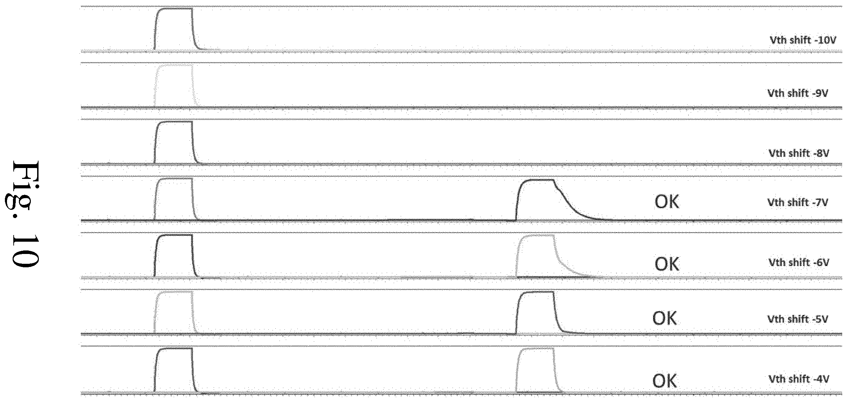

Referring to Figure 10, there is shown a schematic diagram of an endurance simulation waveform of the scanning driving circuit according to this disclosure. As shown in Figure 10, when the threshold voltage Vth is -7V, the scanning driving circuit can still work normally, indicating that the scanning driving circuit of this application is very good in endurance.

The scanning driving circuit prevents electrical leakage by the pull-up circuit, the transfer circuit, the pull-up control circuit, the pull-down holding circuit, the pull-down circuit and the bootstrap circuit, thereby preventing the scanning driving circuit from malfunction caused by the threshold voltage being slightly negative.

## Claims

1. A scanning driving circuit, wherein the scanning driving circuit comprises a plurality of scanning driving units (1) connected in turn, each scanning driving unit (1) comprising:
a scanning signal output terminal (G(n)), for outputting a high voltage level scanning signal or a low voltage level scanning signal;
a pull-up circuit (10), for receiving a staged clock signal (CK(n)) and controlling the scanning signal output terminal to output the high voltage level scanning signal in accordance with the staged clock signal (CK(n));
a transfer circuit (20), connected the pull-up circuit (10), for outputting a staged transmission signal (ST(n)) with high voltage level;
a pull-up control circuit (30), connected to the transfer circuit (20), for charging a pull-up control signal point (Q(n)) to pull electrical potential of the pull-up control signal point (Q(n)) to a high voltage level;
a pull-down holding circuit (40), connected to the pull-up control circuit (30), for maintaining the pull-up control signal point (Q(n)) at a low voltage level and the scanning signal output terminal (G(n)) at a low voltage level; and
a bootstrap circuit (50), for raising electrical potential of the pull-up control signal point (Q(n)), wherein
the pull-up circuit (10) comprises a first controllable switch (T1), wherein a first terminal of the first controllable switch (T1) is configured to receive the staged clock signal (CK(n)) and a second terminal of the first controllable switch (T1) is connected to the scanning signal output terminal (G(n));
the transfer circuit (20) comprises a second controllable switch (T2), wherein a control terminal of the second controllable switch (T2) is connected to a control terminal of the first controllable switch (T1) and to the pull-up control signal point (Q(n)), a first terminal of the second controllable switch (T2) is connected to the first terminal of the first controllable switch (T1), and a second terminal of the second controllable switch (T2) is configured to output the staged transmission signal (ST(n));
the pull-up control circuit (30) comprises third to fifth controllable switches (T3-T5), wherein a control terminal of the third controllable switch (T3) is connected to the control terminal of the second controllable switch (T2) and to a second terminal of the fifth controllable switch (T5), a first terminal of the third controllable switch (T3) is connected to a second terminal of the fourth controllable switch (T4) and to a first terminal of the fifth controllable switch (T5), a first terminal of the fourth controllable switch (T4) is configured to receive a former staged transmission signal (ST(n-4)), and a control terminal of the fourth controllable switch (T4) is connected to a control terminal of the fifth controllable switch (T5) and is configured to receive a first clock signal (XCK); and
the pull-down holding circuit (40) comprises sixth to thirteenth controllable switches (T6-T13), wherein a control terminal of the sixth controllable switch (T6) is connected to the second terminal of the fifth controllable switch (T5), a first terminal of the sixth controllable switch (T6) is connected to a second terminal of the third controllable switch (T3), a second terminal of the sixth controllable switch (T6) is connected to a second terminal of the seventh controllable switch (T7) and to a first terminal of the eighth controllable switch (T8), a first terminal of the seventh controllable switch (T7) is connected to the second terminal of the fifth controllable switch (T5), a control terminal of the seventh controllable switch (T7) is connected to a control terminal of the eighth controllable switch (T8), the second terminal of the eighth controllable switch (T8) is connected to a second voltage terminal (VSS2), a control terminal of the ninth controllable switch (T9) is connected to a first terminal of the ninth controllable switch (T9) and to a first terminal of the eleventh controllable switch (T11) and is configured to receive the staged clock signal (CK(n)), a second terminal of the ninth controllable switch (T9) is connected to a first terminal of the tenth controllable switch (T10) and to a control terminal of the eleventh controllable switch (T11), a control terminal of the tenth controllable switch (T10) is connected to a control terminal of the twelfth controllable switch (T12) and to the pull-up control signal point (Q(n)), a second terminal of the tenth controllable switch (T10) is connected to a first voltage terminal (VSS1), a second terminal of the eleventh controllable switch (T11) is connected to a first terminal of the twelfth controllable switch (T12), to a control terminal of the thirteenth controllable switch (T13), and to the control terminal of the eighth controllable switch (T8), a second terminal of the twelfth controllable switch (T12) is connected to the second voltage terminal (VSS2), a first terminal of the thirteenth controllable switch (T13) is connected to the second terminal of the first controllable switch (T1), to the scanning signal output terminal (G(n)), and to the first terminal of the sixth controllable switch (T6), and a second terminal of the thirteenth controllable switch (T13) is connected to the first voltage terminal (VSS1);
wherein the bootstrap circuit (50) comprises a bootstrap capacitor (C1), wherein one terminal of the bootstrap capacitor (C1) is connected to the control terminal of the third controllable switch (T3), and the other terminal of the bootstrap capacitor (C1) is connected to the second terminal of the third controllable switch (T3).

## Patentansprüche

1. Scanning-Ansteuerschaltung, wobei die Scanning-Ansteuerschaltung eine Vielzahl von Scanning-Ansteuereinheiten (1), die der Reihe nach verbunden sind, umfasst, wobei jede Scanning-Ansteuereinheit (1) umfasst:
eine Scanning-Signalausgabeklemme (G(n)) zum Ausgeben eines Scanning-Signals mit Hochspannungsniveau oder eines Scanning-Signals mit Niederspannungsniveau;
eine Pull-Up-Schaltung (10) zum Empfangen eines stufenweisen Taktgebersignals (CK(n)) und Steuern der Scanning-Signalausgangsklemme, um das Scanning-Signal mit Hochspannungsniveau gemäß dem stufenweisen Taktgebersignal (CK(n)) auszugeben;
eine Transferschaltung (20), die mit der Pull-Up-Schaltung (10) verbunden ist, um ein stufenweises Übertragungssignal (ST(n)) mit Hochspannungsniveau auszugeben;
eine Pull-Up-Steuerschaltung (30), die mit der Transferschaltung (20) verbunden ist, um einen Pull-Up-Steuersignalpunkt (Q(n)) zu laden, um elektrisches Potenzial des Pull-Up-Steuersignalpunkts (Q(n)) zu einem Hochspannungsniveau zu ziehen;
eine Pull-Down-Halteschaltung (40), die mit der Pull-Up-Steuerschaltung (30) verbunden ist, um den Pull-Up-Steuersignalpunkt (Q(n)) an einem Niederspannungsniveau und die Scanning-Signalausgangsklemme (G(n)) an einem Niederspannungsniveau zu halten; und
eine Bootstrap-Schaltung (50) zum Anheben des elektrischen Potenzials des Pull-Up-Steuersignalpunkts (Q(n)), wobei
die Pull-Up-Schaltung (10) einen ersten steuerbaren Schalter (T1) umfasst, wobei eine erste Klemme des ersten steuerbaren Schalters (T1) konfiguriert ist, um das stufenweise Taktgebersignal (CK(n)) zu empfangen, und eine zweite Klemme des ersten steuerbaren Schalters (T1) mit der Scanning-Signalausgangsklemme (G(n)) verbunden ist;
die Transferschaltung (20) einen zweiten steuerbaren Schalter (T2) umfasst, wobei eine Steuerklemme des zweiten steuerbaren Schalters (T2) mit einer Steuerklemme des ersten steuerbaren Schalters (T1) und mit dem Pull-Up-Steuersignalpunkt (Q(n)) verbunden ist, eine erste Klemme des zweiten steuerbaren Schalters (T2) mit der ersten Klemme des ersten steuerbaren Schalters (T1) verbunden ist, und eine zweite Klemme des zweiten steuerbaren Schalters (T2) konfiguriert ist, um das stufenweise Übertragungssignal (ST(n)) auszugeben;
die Pull-Up-Steuerschaltung (30) dritte bis fünfte steuerbare Schalter (T3 bis T5) umfasst, wobei eine Steuerklemme des dritten steuerbaren Schalters (T3) mit der Steuerklemme des zweiten steuerbaren Schalters (T2) und mit einer zweiten Klemme des fünften steuerbaren Schalters (T5) verbunden ist, eine erste Klemme des dritten steuerbaren Schalters (T3) mit einer zweiten Klemme des vierten steuerbaren Schalters (T4) und mit einer ersten Klemme des fünften steuerbaren Schalters (T5) verbunden ist, eine erste Klemme des vierten steuerbaren Schalters (T4) konfiguriert ist, um ein vorheriges stufenweises Übertragungssignal (ST(n-4)) zu empfangen, und eine Steuerklemme des vierten steuerbaren Schalters (T4) mit einer Steuerklemme des fünften steuerbaren Schalters (T5) verbunden ist und konfiguriert ist, um ein erstes Taktgebersignal (XCK) zu empfangen; und
die Pull-Down-Halteschaltung (40) einen sechsten bis dreizehnten steuerbaren Schalter (T6 bis T 13) umfasst, wobei
eine Steuerklemme des sechsten steuerbaren Schalters (T6) mit der zweiten Klemme des fünften steuerbaren Schalters (T5) verbunden ist, eine erste Klemme des sechsten steuerbaren Schalters (T6) mit einer zweiten Klemme des dritten steuerbaren Schalters (T3) verbunden ist, eine zweite Klemme des sechsten steuerbaren Schalters (T6) mit einer zweiten Klemme des siebten steuerbaren Schalters (T7) und einer ersten Klemme des achten steuerbaren Schalters (T8) verbunden ist, eine erste Klemme des siebten steuerbaren Schalters (T7) mit der zweiten Klemme des fünften steuerbaren Schalters (T5) verbunden ist, eine Steuerklemme des siebten steuerbaren Schalters (T7) mit einer Steuerklemme des achten steuerbaren Schalters (T8) verbunden ist, die zweite Klemme des achten steuerbaren Schalters (T8) mit einer zweiten Spannungsklemme (VSS2) verbunden ist, eine Steuerklemme des neunten steuerbaren Schalters (T9) mit einer ersten Klemme des neunten steuerbaren Schalters (T9) und einer ersten Klemme des elften steuerbaren Schalters (T11) verbunden ist und konfiguriert ist, um das stufenweise Taktgebersignal (CK(n)) zu empfangen, eine zweite Klemme des neunten steuerbaren Schalters (T9) mit einer ersten Klemme des zehnten steuerbaren Schalters (T10) und mit einer Steuerklemme des elften steuerbaren Schalters (T11) verbunden ist, eine Steuerklemme des zehnten steuerbaren Schalters (T10) mit einer Steuerklemme des zwölften steuerbaren Schalters (T12) und mit dem Pull-Up-Steuersignalpunkt (Q(n)) verbunden ist, eine zweite Klemme des zehnten steuerbaren Schalters (T10) mit einer ersten Spannungsklemme (VSS1) verbunden ist, eine zweite Klemme des elften steuerbaren Schalters (T11) mit einer ersten Klemme des zwölften steuerbaren Schalters (T12), mit einer Steuerklemme des dreizehnten steuerbaren Schalters (T13) und mit der Steuerklemme des achten steuerbaren Schalters (T8) verbunden ist, eine zweite Klemme des zwölften steuerbaren Schalters (T12) mit der zweiten Spannungsklemme (VSS2) verbunden ist, eine erste Klemme des dreizehnten steuerbaren Schalters (T13) mit der zweiten Klemme des ersten steuerbaren Schalters (T1), mit der Scanning-Signalausgangsklemme (G(n)) und mit der ersten Klemme des sechsten steuerbaren Elements (T6) verbunden ist, und eine zweite Klemme des dreizehnten steuerbaren Schalters (T13) mit der ersten Spannungsklemme (VSS1) verbunden ist;
wobei die Bootstrap-Schaltung (50) einen Bootstrap-Kondensator (C1) umfasst, wobei eine Klemme des Bootstrap-Kondensators (C1) mit der Steuerklemme des dritten steuerbaren Schalters (T3) verbunden ist, und
die andere Klemme des Bootstrap-Kondensators (C1) mit der zweiten Klemme des dritten steuerbaren Schalters (T3) verbunden ist.

## Revendications

1. Circuit d'attaque de balayage, dans lequel le circuit d'attaque de balayage comprend une pluralité d'unités d'attaque de balayage (1) connectées de manière séquentielle, chaque unité d'attaque de balayage (1) comprenant :
une borne de sortie de signal de balayage (G (n)), pour sortir un signal de balayage de niveau de tension élevée ou un signal de balayage de niveau de tension basse ;
un circuit d'excursion haute (10), pour recevoir un signal d'horloge étagé (CK(n)) et commander la borne de sortie de signal de balayage pour sortir le signal de balayage de niveau de tension élevée selon le signal d'horloge étagé (CK(n)) ;
un circuit de transfert (20), connecté au circuit d'excursion haute (10) pour sortir un signal d'émission étagé (ST(n)) avec un niveau de tension élevée ;
un circuit de commande d'excursion haute (30), connecté au circuit de transfert (20), pour charger un point de signal de commande d'excursion haute (Q(n)) pour tirer un potentiel électrique du point de signal de commande d'excursion haute (Q(n)) à un niveau de tension élevée ;
un circuit de maintien d'excursion basse (40), connecté au circuit de commande d'excursion haute (30), pour maintenir le point de signal de commande d'excursion haute (Q(n)) à un niveau de tension basse et la borne de sortie de signal de balayage (G(n)) à un niveau de tension basse ; et
un circuit autoélévateur (50), pour élever un potentiel électrique du point de signal de commande d'excursion haute ((n)), dans lequel
le circuit d'excursion haute (10) comprend un premier commutateur pouvant être commandé (T1), dans lequel une première borne du premier commutateur pouvant être commandé (T1) est configurée pour recevoir le signal d'horloge étagé (CK(n)) et une seconde borne du premier commutateur pouvant être commandé (T1) est connectée à la borne de sortie de signal de balayage (G(n)) ;
le circuit de transfert (20) comprend un deuxième commutateur pouvant être commandé (T2), dans lequel une borne de commande du deuxième commutateur pouvant être commandé (T2) est connectée à une borne de commande du premier commutateur pouvant être commandé (T1) et au point de signal de commande d'excursion haute (Q(n)),
une première borne du deuxième commutateur pouvant être commandé (T2) est connectée à la première borne du premier commutateur pouvant être commandé (T1), et une seconde borne du deuxième commutateur pouvant être commandé (T2) est configurée pour sortir le signal d'émission étagé (ST(n)) ;
le circuit de commande d'excursion haute (30) comprend des troisième à cinquième commutateurs pouvant être commandés (T3-T5), dans lesquels une borne de commande du troisième commutateur pouvant être commandé (T3) est connectée à la borne de commande du deuxième commutateur pouvant être commandé (T2) et à une seconde borne du cinquième commutateur pouvant être commandé (T5), une première borne du troisième commutateur pouvant être commandé (T3) est connectée à une seconde borne du quatrième commutateur pouvant être commandé (T4) et à une première borne du cinquième commutateur pouvant être commandé (T5),
une première borne du quatrième commutateur pouvant être commandé (T4) est configurée pour recevoir un ancien signal d'émission étagé (ST(n-4)), et une borne de commande du quatrième commutateur pouvant être commandé (T4) est connectée à une borne de commande du cinquième commutateur pouvant être commandé (T5) et est configurée pour recevoir un premier signal d'horloge (XCK) ; et
le circuit de maintien d'excursion basse (40) comprend des sixième à treizième commutateurs pouvant être commandés (T6-T13), dans lesquels
une borne de commande du sixième commutateur pouvant être commandé (T6) est connectée à la seconde borne du cinquième commutateur pouvant être commandé (T5), une première borne du sixième commutateur pouvant être commandé (T6) est connectée à une seconde borne du troisième commutateur pouvant être commandé (T3), une seconde borne du sixième commutateur pouvant être commandé (T6) est connectée à une seconde borne du septième commutateur pouvant être commandé (T7) et à une première borne du huitième commutateur pouvant être commandé (T8), une première borne du septième commutateur pouvant être commandé (T7) est connectée à la seconde borne du cinquième commutateur pouvant être commandé (T5), une borne de commande du septième commutateur pouvant être commandé (T7) est connectée à une borne de commande du huitième commutateur pouvant être commandé (T8), la seconde borne du huitième commutateur pouvant être commandé (T8) est connectée à une seconde borne de tension (VSS2), une borne de commande du neuvième commutateur pouvant être commandé (T9) est connectée à une première borne du neuvième commutateur pouvant être commandé (T9) et à une première borne du onzième commutateur pouvant être commandé (T11) et est configurée pour recevoir le signal d'horloge étagé (CK(n)), une seconde borne du neuvième commutateur pouvant être commandé (T9) est connectée à une première borne du dixième commutateur pouvant être commandé (T10) et à une borne de commande du onzième commutateur pouvant être commandé (T11), une borne de commande du dixième commutateur pouvant être commandé (T10) est connectée à une borne de commande du douzième commutateur pouvant être commandé (T12) et au point de signal de commande d'excursion haute (Q(n)), une seconde borne du dixième commutateur pouvant être commandé (T10) est connectée à une première borne de tension (VSS1), une seconde borne du onzième commutateur pouvant être commandé (T11) est connectée à une première borne du douzième commutateur pouvant être commandé (T12), à une borne de commande du treizième commutateur pouvant être commandé (T13), et à la borne de commande du huitième commutateur pouvant être commandé (T8), une seconde borne du douzième commutateur pouvant être commandé (T12) est connectée à la seconde borne de tension (VSS2), une première borne du treizième commutateur pouvant être commandé (T13) est connectée à la seconde borne du premier commutateur pouvant être commandé (T1), à la borne de sortie de signal de balayage (G(n)) et à la première borne du sixième commutateur pouvant être commandé (T6) et une seconde borne du treizième commutateur pouvant être commandé (T13) est connectée à la première borne de tension (VSS1) ;
dans lequel le circuit autoélévateur (50) comprend un condensateur autoélévateur (C1), dans lequel une borne particulière du condensateur autoélévateur (C1) est connectée à la borne de commande du troisième commutateur pouvant être commandé (T3), et
l'autre borne du condensateur autoélévateur (C1) est connectée à la seconde borne du troisième commutateur pouvant être commandé (T3).
